Europäisches Patentamt

**European Patent Office**

Office européen des brevets

(19)

(11) Veröffentlichungsnummer : **0 032 737**
**B1**

# (12) EUROPÄISCHE PATENTSCHRIFT

(45) Veröffentlichungstag der Patentschrift :
18.01.84

(21) Anmeldenummer : **81100312.8**

(22) Anmeldetag : **16.01.81**

(51) Int. Cl.³ : **H 03 H 19/00**

(54) **Elektrische Filterschaltung unter Verwendung von wenigstens einer simulierten Induktivität, die gesteuerte Schalter, Kondensatoren und Verstärker enthält.**

(30) Priorität : **21.01.80 DE 3002041**

(43) Veröffentlichungstag der Anmeldung :
**29.07.81 Patentblatt 81/30**

(45) Bekanntmachung des Hinweises auf die Patenterteilung : **18.01.84 Patentblatt 84/03**

(84) Benannte Vertragsstaaten :
**AT BE CH FR GB IT LI NL SE**

(56) Entgegenhaltungen :
**EP-A- 0 024 011**
**ELECTRONICS LETTERS, Band 15, Nr. 16, 2. August 1979, Seiten 494-496 London, G.B. U.W. BRUGGER et al.: « Switched-capacitor simulation of floating inductors using gyrators"**
**ELECTRONICS LETTERS, Band 14, Nr. 24, 23. November 1978, Seiten 788-790 London, G.B. B.J. HOSTICKA et al.: "Switched-capacitor simulation of grounded inductors and gyrators"**
**ELECTRONICS LETTERS, Band 16, Nr. 4, 14. Februar 1980, Seiten 141-142 Hitchin, G.B. J.A. NOSSEK: "Improved circuit for switched-capacitor simulation of an inductor"**
**IEEE TRANSACTIONS ON CIRCUITS, Band CAS-27, Nr. 6, Juni 1980, Seiten 481-491 New York, U.S.A. J.A. NOSSEK et al.: « Switched-capacitor filter design using bilinear element modeling"**
**ELECTRONICS LETTERS, Band 15, Nr. 3, 1. Februar 1979, Seiten 87-88 London, G.B. G.C. TEMES et al.: "Switched-capacitor circuits bilinearly equivalent to floating inductor or F.D.N.R."**

(73) Patentinhaber : **SIEMENS AKTIENGESELLSCHAFT Berlin und München Wittelsbacherplatz 2 D-8000 München 2 (DE)**

(72) Erfinder : **Nossek, Josef Dipl.-Ing. Noestrasse 30 D-8000 München 71 (DE)**

Elektrische Filterschaltung unter Verwendung von wenigstens einer simulierten Induktivität, die gesteuerte Schalter, Kondensatoren und Verstärker enthält

Die Erfindung betrifft eine elektrische Filterschaltung unter Verwendung von wenigstens einer simulierten Induktivität, die nach vorgegebenen Taktphasen gesteuerte Schalter, Kondensatoren und Verstärker enthält, und die eine invertierende Integrationsschaltung aufweist, bestehend aus einem Operationsverstärker, über dessen Ausgang ein Kondensator mit dem invertierenden Eingang dieses Verstärkers verbunden ist, und bei der ein erster Kondensator vorhanden ist, welcher während einer ersten Taktphase an ein Klemmenpaar angeschaltet ist. Schalterfilter dieser Art sind aus der Zeitschrift « Electronic Letters », Band 15, Nr. 16, 2. August 1979, Seiten 494 bis 496, bekannt. Es werden dabei Gyratoren zur Spulennachbildung angewendet.

Schalterfilter sind auch bereits durch den Aufsatz « Switched-Capacitor Filter Disign Using the Bilinear z-Transfrom » in der Zeitschrift « IEEE Transactions on Circuits and Systems », Vol Cas-25, Nr. 12, Dez. 1978, Seiten 1039 bis 1044 und auch durch die Arbeit « Switched-Capacitor Circuits Bilinearly Equivalent to Floating Inductor or F.D.N.R. » in der Zeitschrift Electronics Letters, 1. Febr. 1979, Vol 15, Nr. 3, Seiten 87 und 88, bekannt geworden. Es handelt sich dabei um solche Filter, die nicht zeitkontinuierliche Analogsignale im eigentlichen Sinne verarbeiten, sondern zeitdiskrete Signale, die in Form von Abtastproben vorliegen, wobei die Abtastproben im Rhythmus einer Abtastfrequenz F erzeugt werden und über die Beziehung $T = 1/F$ wird dementsprechend T die Abtastperiode genannt. Schaltungen zur Erzeugung solcher Abtastproben sind für sich bekannt, so daß sie an dieser Stelle nicht im einzelnen erläutert werden müssen. Es ist jedoch auch im folgenden davon auszugehen, daß den dargestellten Schaltungen solche Abtastschaltungen jeweils vor- bzw. nachgeschaltet sein können, so daß es also einerseits gelingt, aus einem Analogsignal entnommene Abtastproben der Filterschaltung eingangsseitig zuzuführen und die ausgangsseitig zur Verfügung stehenden Signale wieder in zeitkontinuierliche Analogsignale umzuwandeln. Der wesentliche technische Vorteil solcher Filter ist darin zu sehen, daß Spulen durch aktive Schaltelemente und Kondensatoren nachgebildet werden, so daß sie sich zur monolithischen Integration von größeren Filterschaltungen eignen. Als Verstärker werden dabei überwiegend die bekannten Operationsverstärker eingesetzt und es wird dabei angestrebt, einerseits eine möglichst geringe Anzahl von Schaltelementen anwenden zu müssen und andererseits auch die Stabilität solcher Schaltungen zu gewährleisten. Bei den vorerwähnten bekannten Schaltungen wird ebenfalls der invertierende Eingang mit dem Ausgang eines Operationsverstärkers über einen Kondensator verbunden, also gewissermaßen gegengekoppelt. Jedoch zeigt sich, daß die zum Einsatz kommenden· Operationsverstärker zeitweilig nicht gegengekoppelt sind bzw. eine hohe Gleichtaktunterdrückung benötigen, da der nicht invertierende Eingang des Operationsverstärkers während gewisser Schaltphasen kurzzeitig nicht gegengekoppelt ist bzw. nicht stets auf Massepotential gehalten wird. Weiterhin erfolgt die Realisierung der Kondensatoren in der Art der MOS-Technologie (Metalloxydsilizium-Technologie) und es zeigt sich, daß bei diesen Realisierungsverfahren die unvermeidlichen mit jedem schwebenden MOS-Kondensator verbundenen Erdkapazitäten zu erheblichen Störungen der Filterfunktion führen können.

Der Erfindung liegt die Aufgabe zugrunde, unter Verwendung von wenigstens einer simulierten Induktivität Schaltungsstrukturen anzugeben, die zur Realisierung eines Parallelresonanzkreises geeignet sind ; die Resonanzfrequenz dieser Parallelresonanzkreise beträgt dabei ein Sechstel der Abtastfrequenz.

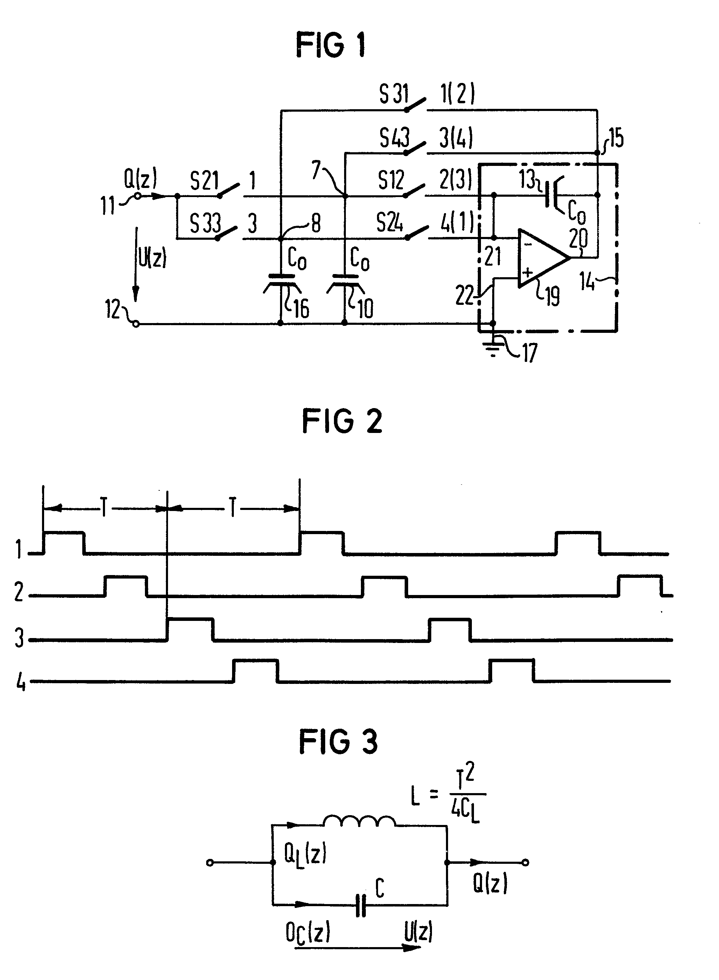

Von den einleitend genannten Schaltungen ausgehend, wird diese Aufgabe erfindungsgemäß dadurch gelöst, daß zur Realisierung eines Parallelresonanzkreises, dessen Resonanzfrequenz ein Sechstel der Abtastfrequenz beträgt, ein erster Kondensator während einer ersten Taktphase an ein Klemmenpaar angeschaltet ist und gleichzeitig ein zweiter Kondensator an den Ausgang einer invertierenden Integrationsschaltung angeschaltet ist, daß anschließend während einer zweiten Taktphase der erste Kondensator seine Ladung an einen Kondensator der Integrationsschaltung abgibt, in einer dritten Taktphase vom Ausgang der Integrationsschaltung aufgeladen wird, und dabei gleichzeitig der zweite Kondensator an das Klemmenpaar angeschaltet ist, der seinerseits während einer darauffolgenden, vierten Taktphase seine Ladung an den Kondensator der Integrationsschaltung abgibt. Fig. 1, 2, 3, 4.

Vorteilhafte Ausgestaltung und Weiterbildungen sind in den Unteransprüchen angegeben.

Die Erfindung wird im folgenden anhand von Ausführungsbeispielen näher erläutert.

Es zeigen in der Zeichnung

Figur 1 eine erste Schaltungsstruktur zur Realisierung eines Parallelresonanzkreises mit der Resonanzfrequenz F/6 ;

Figur 2 das Taktschema, mit dem die Schaltungen nach den Figuren 1 und 4 betrieben werden ;

Figur 3 das elektrische Ersatzschaltbild für die vorstehend genannten Schaltungsstrukturen, wobei dem Kondensator C die Spule L parallelgeschaltet ist ;

Figur 4 eine Schaltungsstruktur zur Realisierung eines schwebenden Parallelresonanzkreises mit der Resonanzfrequenz F/6 ;

Figur 5 ein Beispiel für weitere Ausgestaltungsmöglichkeiten ;

Figur 6 ein Taktschema, mit dem Schaltungen nach Fig. 5 betrieben werden können.

Die Schaltung von Fig. 1 wirkt an ihren Eingangsklemmen 11, 12 als elektrischer Zweipol, dessen elektrisches Ersatzschaltbild in Fig. 3 dargestellt ist. Der gestrichelt eingerahmte Schaltungsabschnitt 14 ist als invertierende Integrationsschaltung ausgebildet. Der innere Schaltungsaufbau dieser Integrationsschaltung ist ebenfalls zu erkennen, jedoch können auch andere invertierende Integrationsschaltungen verwendet werden. Im Ausführungsbeispiel besteht die Integrationsschaltung 14 aus einem Operationsverstärker 19, dessen invertierender Eingang mit der Bezugsziffer 21, dessen nicht invertierender Eingang mit der Bezugsziffer 22 und dessen Ausgang mit der Bezugsziffer 20 versehen ist. Der Ausgang 20 des Operationsverstärkers stellt also zugleich den Ausgang 15 der Integrationsschaltung 14 dar, der nicht invertierende Eingang 22 liegt auf dem durch die Bezugsziffer 17 kenntlich gemachten Bezugspotential. Der Ausgang 20 ist zur Gegenkopplung mit dem Kondensator 13, dessen Kapazitätswert mit $C_0$ bezeichnet ist, mit dem invertierenden Eingang 21 verbunden.

Der Eingangsklemme 11 folgen die parallel liegenden Schalter S21 und S33, von denen der Schalter S21 auf einen Schaltungsknoten 7, der Schalter S33 auf einen Schaltungsknoten 8 führt. Zwischen den Knoten 7 bzw. 8 und Bezugspotential 17 liegen die Kondensatoren 10 bzw. 16, deren Kapazitätswerte ebenfalls mit $C_0$ angegeben sind. In der Schaltungsstruktur sind ferner zu erkennen die Schalter S31, über den der Ausgang 15 der Integrationsschaltung mit dem Schaltungsknoten 8 verbunden ist, der Schalter S43, der den Ausgang 15 mit dem Schaltungsknoten 7 verbindet, der Schalter S12, der den invertierenden Eingang 13 mit dem Schaltungsknoten 7 verbindet und schließlich ein Schalter S24, der den invertierenden Eingang 21 mit dem Schaltungsknoten 8 verbindet.

Fig. 2 zeigt das Taktschema, mit dem die Schalter betrieben werden, wobei die Taktphasen 1, 2, 3 und 4 erkennbar sind, die so ausgestaltet sind, daß sich die einzelnen Schließungsdauern der Schalter nicht überlappen. In Fig. 2 ist dabei gleichzeitig eine vorteilhafte Aufteilung der einzelnen Taktphasen insofern gezeichnet, als die systemeigene Abtastfrequenz 1/T gleich der doppelten Taktfrequenz für die Schaltung ist.

In Fig. 1 sind an den einzelnen Schaltern unmittelbar die Taktphasen 1 bis 4 angeschrieben, in denen sie jeweils geschlossen sind. Weiterhin sind in Klammern weitere Möglichkeiten für die Schalterbetätigung angegeben und es können demzufolge die Schalter S31 bzw. S43 bzw. S12 bzw. S24 jeweils während der Taktphase 1 bzw. 3 bzw. 2 bzw. 4 oder während der Taktphase 2 bzw. 4 bzw. 3 bzw. 1 geschlossen werden.

Wenn die vorstehend beschriebene Betriebsweise für die Schalterfolge eingehalten wird, dann wird also während der ersten Taktphase 1 der erste Kondensator 10 aufgeladen und gleichzeitig der zweite Kondensator 16 an den Ausgang 15 der invertierenden Integrationsschaltung geschaltet. Anschließend gibt der Kondensator 10 seine Ladung an den Kondensator 13 ab und es wird nachfolgend in der dritten Taktphase der Kondensator 10 vom Ausgang der Integrationsschaltung 14 aufgeladen. Zugleich ist der zweite Kondensator 16 an das Klemmenpaar 11, 12 angeschaltet. In der vierten Taktphase gibt schließlich der Kondensator 16 seine Ladung an den Kondensator 13 ab.

Eine vorteilhafte Bemessung läßt sich erreichen, wenn die Kondensatoren 10, 13 und 16 unter sich den gleichen Kapazitätswert $C_0$ haben.

Nach dem elektrischen Ersatzschaltbild von Fig. 3 wird in der Induktivität L die Ladung $Q_L(z)$ transportiert, im Kondensator C die Ladung $Q_C(z)$, die Gesamtladung ist mit $Q(z)$ bezeichnet und es tritt der Spannungsabfall $U(z)$ auf. Für die Resonanzfrequenz F/6 läßt sich dieser Parallelresonanzkreis unmittelbar mit der Schaltung von Fig. 1 realisieren, das heißt, es wird also an der Eingangsklemme 11 die Ladung $Q(z)$ aufgenommen und es fällt zwischen den Klemmen 11 und 12 die Spannung $U(z)$ ab, wenn die Kondensatoren nach der Vorschrift $C_0 = C + C_L$ bemessen sind, mit $C_L = T^2/4L$.

Ganz allgemein kann man sagen, daß sich mit der anhand der Fig. 1 bis 3 geschilderten Schaltung ein geerdeter Parallelschwingkreis ebenfalls realisieren läßt, wenn der erste und zweite Kondensator 10 und 16 und auch die Integrationsschaltung 14 an Bezugspotential geschaltet sind. Diese Ausführungsform ist in Fig. 1 durch das mit 17 bezeichnete Bezugspotential dargestellt, an das einseitig die Kondensatoren 10 und 16 und auch die Eingangsklemme 12 angeschaltet sind. Erforderlichenfalls läßt sich die Schaltung nach Fig. 1 auch bezugspotentialfrei betreiben.

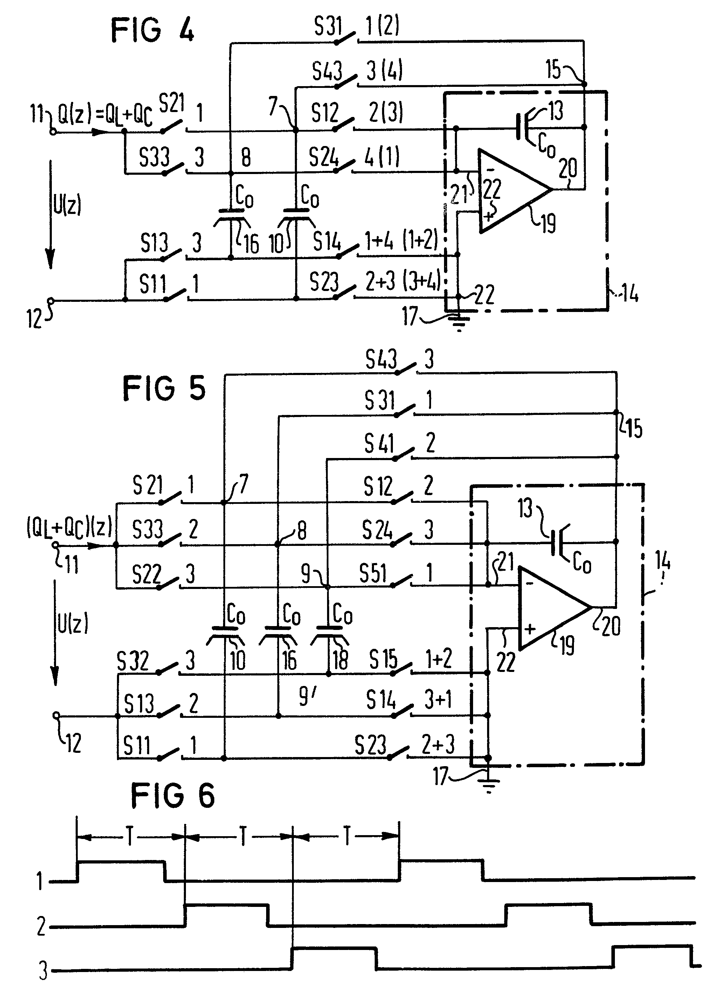

Die Schaltung nach Fig. 4 eignet sich zur Realisierung eines schwebenden Parallelresonanzkreises mit der Resonanzfrequenz F/6, das heißt also eines Resonanzkreises, der einseitig nicht auf Bezugspotential liegt. Ein Vergleich der Fig. 1 und 4 läßt unmittelbar erkennen, daß die Schaltungen hinsichtlich ihrer Strukturen und ihrer Betriebsweise hinsichtlich den Taktphasen im wesentlichen übereinstimmen und da wirkungsgleiche Elemente mit gleichen Bezugsziffern versehen sind, gelten die zu Fig. 1 bis 3 gemachten Ausführungen analog auch für Fig. 4.

Unterschiedlich sind einige zusätzliche Schalter, die nachfolgend an die zweite Klemme 12 geschaltet sind. Es sind dies im Ausführungsbeispiel der Fig. 4 die Schalter S13 und S11 bzw. die dem nicht invertierenden Eingang 12 des Operationsverstärkers 19 vorgeschalteten Schalter S14 und S23. Der Schalter S13 schließt entsprechend Fig. 1 zur Taktphase 3, der Schalter S11 zur Taktphase 1. Der Schalter S14 muß während der Taktphasen 1 und 4 und der Schalter S23 während der Taktphasen 2 und 3 geschlossen sein. Entsprechend den eingeklammerten Angaben, nach denen die Schalter S31 bzw. S43 bzw. S12 bzw. S24 auch während der Taktphasen 2 bzw. 4 bzw. 3 bzw. 1 geschlossen sein können, müssen zur Erhaltung der gleichen Wirkungsweise dann die Schalter S14 bzw. S23 entsprechend während der Taktphasen 1 und 2 bzw. 3 und 4 geschlossen sein.

Eine weitere Schaltungsvariante ist in Fig. 5 gezeigt, eine Schaltung, mit der sich ebenfalls ein schwebender Parallelresonanzkreis nach dem Ersatzschaltbild von Fig. 3 realisieren läßt. Das zugehörige Taktschema mit den Taktphasen 1, 2 und 3 zeigt Fig. 6.

Die zu den Fig. 1 bis 4 gegebenen Erläuterungen lassen sich analog auch auf die Schaltung von Fig. 5 anwenden.

Im Ausführungsbeispiel von Fig. 5 werden zwei zusätzliche Schalter S22 und S32 eingeführt, die den Eingangsklemmen 11 und 12 folgen und die während der Taktphase 3 geschlossen sind. Der Schalter S22 führt auf einen Schaltungsknoten 9, von dem aus der zur Taktphase 1 schließende Schalter S51 auf den invertierenden Eingang 21 des Operationsverstärkers 19 weiterführt. Symmetrisch dazu folgt dem Schalter S32 ein Schaltungsknoten 9', von dem aus über einen weiteren Schalter S15 der nicht invertierende Eingang 22 des Operationsverstärkers 19 erreicht wird. Der Schalter S15 schließt während der Taktphasen 1 und 2, der Schalter S14 während der Taktphasen 3 und 1 und der Schalter S23 während der Taktphasen 2 und 3.

Zwischen den Schaltungsknoten 9 und 9' liegt ein zusätzlicher Kondensator 18, der den Kapazitätswert $C_0$ hat. Die Kondensatoren 10 bzw. 16 haben ebenfalls den Kapazitätswert $C_0$.

Im Ausführungsbeispiel von Fig. 5 ist nur ein weiterer Kondensator zugeschaltet. Es können jedoch weitere Kondensatoren 18 zugeschaltet werden, wobei dann entsprechend der Schaltungsergänzung von Fig. 4 auf Fig. 5 auch weitere Schalter eingeführt werden müssen. Für diese Schaltungen gilt ebenso wie für die Schaltung nach Fig. 5 ganz allgemein, daß die Abtastfrequenz 1/T den (2 + n)-fachen Wert der Taktfrequenz gemäß Fig. 6 beträgt. Dabei ist n die Zahl der weiteren Kondensatoren 18. Diese zusätzlichen Kondensatoren werden also abwechselnd mit den Kondensatoren 10, 16 an das Klemmenpaar 11, 12 bzw. an den Ausgang 15 der Integrationsschaltung 14 geschaltet und geben ihre Ladung an den Kondensator 13 ab.

Wie bereits erwähnt, bieten die vorstehend beschriebenen Schaltungen die Möglichkeit zur Realisierung von Parallelresonanzkreisen mit der Resonanzfrequenz F/6, wobei einerseits die Integrierbarkeit der Schaltung gewährleistet und andererseits sichergestellt ist, daß auch während der Schaltvorgänge der einzelnen Schalter die Integrationsschaltung 14 so ausgebildet werden kann, daß die Gegenkopplung zwischen dem Ausgang 20 und dem invertierenden Eingang 21 über den Kondensator 13 stets erhalten bleiben kann.

**Ansprüche**

1. Elektrische Filterschaltung unter Verwendung von wenigstens einer simulierten Induktivität, die nach vorgegebenen Taktphasen gesteuerte Schalter, Kondensatoren und Verstärker enthält, und die eine invertierende Integrationsschaltung (14) aufweist, bestehend aus einem Operationsverstärker (19), über dessen Ausgang (20) ein Kondensator (13) mit dem invertierenden Eingang (21) dieses Verstärkers (19) verbunden ist, und bei der ein erster Kondensator (10) vorhanden ist, welcher während einer ersten Taktphase (1) an ein Klemmenpaar (11, 12) angeschaltet ist, dadurch gekennzeichnet, daß zur Realisierung eines Parallelresonanzkreises, dessen Resonanzfrequenz ein Sechstel der Abtastfrequenz beträgt, gleichzeitig ein zweiter Kondensator (16) an den Ausgang (15) der invertierenden Integrationsschaltung (14) angeschaltet ist, daß anschließend während einer zweiten Taktphase (2) der erste Kondensator (10) seine Ladung an den Kondensator (13) der Integrationsschaltung (14) abgibt, in einer dritten Taktphase (3) vom Ausgang (15) der Integrationsschaltung (14) aufgeladen wird, und dabei gleichzeitig der zweite Kondensator (16) an das Klemmenpaar (11, 12) angeschaltet ist, der seinerseits während einer darauffolgenden, vierten Taktphase (4) seine Ladung an den Kondensator (13) der Integrationsschaltung (14) abgibt (Fig. 1, 2, 3, 4).

2. Elektrische Filterschaltung nach Anspruch 1, dadurch gekennzeichnet, daß die Abtastfrequenz (1/T) gleich der doppelten Taktfrequenz ist (Fig. 1, 2, 3, 4).

3. Elektrische Filterschaltung nach Anspruch 1 oder 2, dadurch gekennzeichnet, daß sämtliche Kondensatoren (10, 13, 16) den gleichen Kapazitätswert haben (Fig. 1, 2, 3, 4).

4. Elektrische Filterschaltung nach einem der vorhergehenden Ansprüche, dadurch gekennzeichnet, daß Schalter vorgesehen sind, derart, daß zur Realisierung eines geerdeten Parallelschwingkreises der erste Kondensator (10), der zweite Kondensator (16) und die Integrationsschaltung (14) mit jeweils einer an Bezugspotential (17) liegenden Klemme (12) verbunden sind (Fig. 1, 2, 3).

5. Elektrische Filterschaltung nach einem der Ansprüche 1 bis 3, dadurch gekennzeichnet, daß zur Realisierung eines schwebenden Parallelresonanzkreises der erste Kondensator (10) während der ersten Taktphase (1) und der zweite Kondensator (16) während der dritten Taktphase (3) durch zusätzliche Schalter (S23 bzw. S14) vom Bezugspotential (17) abgetrennt und mit der zweiten Eingangsklemme (12) verbunden (S13, S11) werden (Fig. 2, 3, 4).

6. Elektrische Filterschaltung nach einem der vorhergehenden Ansprüche, dadurch gekennzeichnet, daß wenigstens ein weiterer Kondensator (18) vorgesehen ist, der über weitere Schalter (S41, S51) mit den Kondensatoren (10, 16) an das Klemmenpaar (11, 12) bzw. den Ausgang (15) der Integrationsschaltung (14) geschaltet wird und seine Ladung an den Kondensator (13) der Integrationsschaltung (14) abgibt und dabei die Abtastfrequenz (1/T) den (2 + n)-fachen Wert der Taktfrequenz beträgt, wenn n die Zahl der weiteren Kondensatoren (18) ist (Fig. 5, 6).

7. Elektrische Filterschaltung nach einem der vorhergehenden Ansprüche, dadurch gekennzeichnet, daß die Integrationsschaltung (14) von einem Operationsverstärker (19) gebildet ist, dessen Ausgang (20), der gleichzeitig den Ausgang (15) der Integrationsschaltung (14) darstellt, über den ihr zugeordneten Kondensator (13) mit seinem invertierenden Eingang (21) verbunden ist, der gleichzeitig den Eingang der Integrationsschaltung (14) darstellt, und daß sein nicht invertierender Eingang (22) auf Bezugspotential (17) liegt (Fig. 1, 3, 4, 5).

8. Elektrische Filterschaltung nach den Ansprüchen 1 bis 3 und 7, dadurch gekennzeichnet, daß der erste Kondensator (10) mit seinem ersten Anschluß an Bezugspotential (17) und mit seinem zweiten Anschluß einerseits über einen Schalter (S21) mit der ersten Klemme (11), und andererseits über einen Schalter (S12) mit dem invertierenden Eingang (21) des Operationsverstärkers (19) verbunden ist, und weiterhin über einen Schalter (S43) mit dem Ausgang (20) des Operationsverstärkers (19) verbunden ist, und daß der zweite Kondensator (16) mit seinem ersten Anschluß an Massepotential (17) und mit seinem zweiten Anschluß einerseits über einen Schalter (S33) mit der ersten Klemme (11) und andererseits über einen Schalter (S24) mit dem invertierenden Eingang (21) des Operationsverstärkers (19) und weiterhin über einen Schalter (S31) mit dessen Ausgang (20) verbunden ist, von dem aus der Integrationsschaltung (14) zugeordnete Kondensator (13) zum invertierenden Eingang (21) führt und der nicht invertierende Eingang (22) auf Bezugspotential (17) liegt, und daß der Schalter S21 während der ersten und der Schalter S33 während der dritten Taktphase geschlossen ist, und der Schalter S31 während der ersten bzw. zweiten, der Schalter S43 während der dritten bzw. vierten, der Schalter S12 während der zweiten bzw. dritten, und der Schalter S24 während der vierten bzw. ersten Taktphase geschlossen sind (Fig. 1, 2, 3).

9. Elektrische Filterschaltung nach Anspruch 8, dadurch gekennzeichnet, daß der erste Anschluß des ersten Kondensators (10) einerseits über einen Schalter (S11) mit der zweiten Klemme (12) und andererseits über einen Schalter (S23) mit Bezugspotential (17) über den Schalter (S23) verbunden ist und der erste Anschluß des zweiten Kondensators (16) einerseits über einen Schalter (S13) mit der zweiten Klemme (12) und andererseits über einen Schalter (S14) mit Bezugspotential (17) verbunden ist, und daß der Schalter S11 in der ersten und der Schalter S13 in der dritten Taktphase, der Schalter S14 in der ersten und vierten bzw. ersten und zweiten und der Schalter S23 in der zweiten und dritten bzw. dritten und vierten Taktphase geschlossen sind (Fig. 2, 3, 4).

10. Elektrische Filterschaltung nach den Ansprüchen 6, 7 und 9, dadurch gekennzeichnet, daß der weitere Kondensator (18) mit seinem ersten Anschluß einerseits über einen Schalter (S32) mit der zweiten Klemme (12) und andererseits über einen Schalter (S15) mit Bezugspotential (17) und mit seinem zweiten Anschluß einerseits über einen Schalter (S22) mit der ersten Klemme (11) und andererseits über einen Schalter (S51) mit dem invertierenden Eingang (21) des Operationsverstärkers (19) und weiterhin über einen Schalter (S41) mit dessen Ausgang (20) verbunden ist, und daß die Schalter S11, S21, S31, S51 während der ersten, die Schalter S13, S33, S41, S12 während der zweiten, die Schalter S22, S32, S43, S24 während der dritten, der Schalter S15 während der ersten und zweiten, der Schalter S14 während der ersten und dritten, und der Schalter S23 während der zweiten und dritten Taktphase geschlossen sind (Fig. 5, 6).

## Claims

1. An electrical filter circuit employing at least one simulated inductance, which includes switches, capacitors and amplifiers controlled by predetermined clock pulse phases, and which has an inverting integration circuit (14) consisting of an operational amplifier (19) whose output (20) is connected to its inverting input (21) by a capacitor (13) and wherein a first capacitor (10) is connected to a terminal pair (11, 12) during a first clock pulse phase (1), characterised in that in order to construct a parallel resonant circuit, whose resonant frequency amounts to a sixth of the sampling frequency, at the same time a second capacitor is connected to the output (15) of the inverting integration circuit (14), that during a subsequent second clock pulse phase (2) the first capacitor (10) emits its charge to the capacitor (13) of the integration circuit (14) and is then charged from the output (15) of the integration circuit (14) in a third clock pulse phase (3) whilst at the same time the second capacitor (16) is connected to the terminal pair (11, 12), which capacitor in turn subsequently emits its charge to the capacitor (13) of the integration circuit (14) during a fourth clock pulse phase (Fig. 1, 2, 3, 4).

2. An electrical filter circuit as claimed in Claim 1, characterised in that the sampling frequency (1/T) is precisely double the clock pulse frequency (Fig. 1, 2, 3, 4).

3. An electrical filter circuit as claimed in Claim 1 or 2, characterised in that all capacitors (10, 13, 16) have the same capacitance value (Fig. 1, 2, 3, 4).

4. An electrical filter circuit as claimed in one of the preceding Claims, characterised in that switches are provided in such a manner that to construct an earthed parallel oscillatory circuit the first capacitor (10), the second capacitor (16) and the integration circuit (14) are respectively connected to a terminal (12) maintained at reference potential (17) (Fig. 1, 2, 3).

5. An electrical filter circuit as claimed in one of Claims 1 to 3, characterised in that a floating parallel resonant circuit is formed by arranging that during the first clock pulse phase the first capacitor (10) and during the third clock pulse phase (3) the second capacitor (16) are separated from the reference potential (17) by additional switches (S23 or S14 as the case may be) and are connected (S13, S11) to the second input terminal (12) (Fig. 2, 3, 4).

6. An electrical filter circuit as claimed in one of the preceding Claims, characterised in that there is at least one further capacitor (18) connected by further switches (S41, S51) and the respective capacitors (10, 16) to the terminal pair (11, 12) or the output (15) of the integration circuit (14), as the case may be, so that it emits its charge to the capacitor (13) of the integration circuit (14), and the sampling frequency (1/T) has a value of (2 + n) times the clock pulse frequency, where n is the number of the further capacitors (18) (Fig. 5, 6).

7. An electrical filter circuit as claimed in one of the preceding Claims, characterised in that the integration circuit (14) is formed by an operational amplifier (19) whose output (20) constitutes the output (15) of the integration circuit (14) is connected to the inverting input (21) of said operational amplifier by means of the capacitor (13) assigned to said integration circuit (14), which input (21) simultaneously constitutes the input of the integration circuit (14), and that the non-inverting input (22) of said operational amplifier is connected to reference potential (17) (Fig. 1, 3, 4, 5).

8. An electrical filter circuit as claimed in Claims 1 to 3 and 7, characterised in that the first capacitor (10) has its first electrode connected to reference potential (17) and its second electrode to the first terminal (11) by a switch (S21) and to the inverting input (21) of the operational amplifier (19) by means of a switch (S12), and is further connected to the output (20) of the operational amplifier (19) by a switch (S43), and that the second capacitor (16) has its first electrode connected to earth potential (17) and its second electrode to the first terminal (11) by a switch (S33) and to the inverting input (21) of the operational amplifier (19) by a switch (S24), and is further connected to the output (20) of said operational amplifier by a switch (S31), from which output (20) the capacitor (13) assigned to the integration circuit (14) leads to the inverting input (21) and the non-inverting input (22) is connected to reference potential (17), and that switch S21 is closed during the first clock pulse phase and switch S33 is closed during the third clock pulse phase, and switch S31 is closed during the first and second clock pulse phases, switch S43 during the third and fourth, switch S12 during the second and third, and switch S24 during the fourth and first clock pulse phases (Fig. 1, 2, 3).

9. An electrical filter circuit as claimed in Claim 8, characterised in that the first electrode of the first capacitor (10) is connected to the second terminal (12) by a switch (S11) to reference potential (17) by the switch (S23), and the first electrode of the second capacitor (16) is connected to the second terminal (12) by a switch (S13) and to reference potential (17) by a switch (S14), and that switch S11 is closed in the first clock pulse phase, switch S13 in the third clock pulse phase, switch S14 in the first and fourth or first and second clock pulse phase, as the case may be, and switch S23 is closed in the second and third or third and fourth clock pulse phase, as the case may be (Fig. 2, 3, 4).

10. An electrical filter circuit as claimed in Claims 6, 7 and 9, characterised in that the further capacitor (18) has its first electrode connected to the second terminal (12) by a switch (S32) and to reference potential (17) by a switch (S15) and has its second electrode connected to the first terminal (11) by a switch (S22) and to the inverting input (21) of the operational amplifier (19) by a switch (S51) and is further connected to the output (20) of the operational amplifier (19) by a switch (S41), and that the switches (S11, S21, S31, S51 are closed during the first clock pulse phase, the switches S13, S33, S41, S12 are closed during the second clock pulse phase, the switches S22, 32, S43, S24 are closed during the third clock pulse phase, switch S15 is closed during the first and second clock pulse phase, switch S14 is closed during the first and third clock pulse phase, and switch S23 is closed during the second and third clock pulse phase (Fig. 5, 6).

**Revendications**

1. Circuit de filtre électrique utilisant au moins une inductance simulée, qui contient des commutateurs commandés selon des phases de cadence prédéterminées, des condensateurs et des amplificateurs, et qui possède un circuit d'intégration inverseur (14) constitué par un amplificateur opérationnel (19), dont la sortie (20) est reliée par l'intermédiaire d'un condensateur (13) à l'entrée inverseuse (21) de cet amplificateur (19), et dans lequel il est prévu un premier condensateur (10) qui est raccordé à un couple de bornes (11, 12) pendant une première phase de cadence (1), caractérisé par le fait que pour réaliser un circuit résonnant parallèle, dont la fréquence de résonance est égale à un sixième de la fréquence d'exploration, un second condensateur (16) est simultanément raccordé à la sortie (15) du circuit d'intégration inverseur (14), qu'ensuite pendant une seconde phase de cadence (2), le premier condensateur (10) délivre sa charge à un condensateur (13) du circuit d'intégration (14) et est chargé, pendant une troisième phase de cadence (3), par la sortie (15) du circuit d'intégration (14), et que simultanément au couple de bornes (11, 12) est raccordé le second condensateur (16) qui pour sa part délivre, pendant une quatrième phase de cadence suivante (4), sa charge au condensateur (13) du circuit d'intégration (14) (Figures 1, 2, 3, 4).

2. Circuit de filtre électrique suivant la revendication 1, caractérisé par le fait que la fréquence d'exploration (1/T) est égale au double de la fréquence de cadence (Figures 1, 2, 3, 4).

3. Circuit de filtre électrique suivant la revendication 1 ou 2, caractérisé par le fait que tous les condensateurs (10, 13, 16) possèdent une capacité de même valeur (Figures 1, 2, 3, 4).

4. Circuit de filtre électrique suivant l'une des revendications précédentes, caractérisé par le fait que des commutateurs sont prévus de telle sorte que pour la réalisation d'un circuit oscillant parallèle mis à la terre, le premier condensateur (10), le second condensateur (16) et le circuit d'intégration (14) sont reliés à une borne respective (12) placée au potentiel de référence (Figures 1, 2, 3).

5. Circuit de filtre électrique suivant l'une des revendications 1 à 3, caractérisé par le fait que pour la réalisation d'un circuit résonnant parallèle flottant, le premier condensateur (10) et le second condensateur (16) sont séparés du potentiel de référence (17) respectivement pendant la première phase de cadence (1) et la troisième phase de cadence (3) au moyen de commutateurs supplémentaires (S23 et S14) et sont reliés (S13, S11) à la seconde borne d'entrée (12) (Figures 2, 3, 4).

6. Circuit de filtre électrique suivant l'une des revendications précédentes, caractérisé par le fait qu'il est prévu au moins un autre condensateur (18) qui est raccordé par l'intermédiaire d'autres commutateurs (S41, S51), en association avec les condensateurs (10, 16), au couple de bornes (11, 12) ou à la sortie (15) du circuit d'intégration (14) et délivre sa charge au condensateur (13) du circuit d'intégration (14), et que la fréquence d'exploration (1/T) possède une valeur égale à (2 + n) fois la fréquence de cadence, n étant le nombre des autres condensateurs (18) (Figures 5, 6).

7. Circuit de filtre électrique suivant l'une des revendications précédentes, caractérisé par le fait que le circuit d'intégration (14) est formé par un amplificateur opérationnel (19) dont la sortie (20), qui constitue simultanément la sortie (15) du circuit d'intégration (14), est reliée par l'intermédiaire du condensateur (13), qui est associé à ce circuit, à l'entrée inverseuse (21) dudit amplificateur, qui représente simultanément une entrée du circuit d'intégration (14), et que son entrée non inverseuse (23) est placée au potentiel de référence (17) (Figures 1, 2, 3, 4, 5).

8. Circuit de filtre électrique suivant les revendications 1 à 3 et 7, caractérisé par le fait que le premier condensateur (10) est relié par sa première borne au potentiel de référence (17) et par sa seconde borne d'une part par l'intermédiaire du commutateur (S21) à la première borne (11) et d'autre part par l'intermédiaire d'un commutateur (S12) à l'entrée inverseuse (21) de l'amplificateur opérationnel (19), et en outre par l'intermédiaire d'un commutateur (S43) à la sortie (20) de l'amplificateur opérationnel (19), et que le second condensateur (16) est relié par sa première borne au potentiel de la masse (17) et par sa seconde borne d'une part par l'intermédiaire d'un commutateur (S33) à la première borne (11) et d'autre part par l'intermédiaire d'un commutateur (S24) à l'entrée inverseuse (21) de l'amplificateur opérationnel (19) et en outre par l'intermédiaire d'un commutateur (S31) à la sortie (20) de cet amplificateur, qu'un condensateur (13) associé au circuit d'intégration (14) relie à l'entrée inverseuse (21), tandis que l'entrée non inverseuse (22) est placée au potentiel de référence (17), et que le commutateur (S21) est fermé pendant la première phase de cadence, que le commutateur (S33) est fermé pendant la troisième phase de cadence, que le commutateur (S31) est fermé pendant la première ou la seconde phase de cadence, que le commutateur (S43) est fermé pendant la troisième ou la quatrième phase de cadence, que le commutateur (S12) est fermé pendant la seconde ou la troisième phase de cadence et que le commutateur (S24) est fermé par la quatrième ou la première phase de cadence (Figures 1, 2, 3).

9. Circuit de filtre électrique selon la revendication 8, caractérisé par le fait que la première borne du condensateur (10) est reliée d'une part par l'intermédiaire d'un commutateur (S11) à la seconde borne (12) et d'autre part par l'intermédiaire d'un commutateur (S23) au potentiel de référence (17), et que la première borne du second condenseur (16) est reliée d'une part par l'intermédiaire d'un commutateur (S13) à la seconde borne (12) et d'autre part par l'intermédiaire d'un commutateur (S14) au potentiel de référence (17), et que le commutateur (S11) est fermé pendant la première phase de cadence, que le commutateur (S16) est fermé pendant la troisième phase de cadence, le commutateur (S14) est fermé pendant la première et la quatrième phases de cadence ou pendant la première et la deuxième phases de cadence et que le commutateur (S23) est fermé pendant la seconde et la troisième phases de cadence ou pendant la troisième ou la quatrième phases de cadence (Figures 2, 3, 4).

10. Circuit de filtre électrique suivant la revendication 6, 7 et 9, caractérisé par le fait que l'autre condensateur (18) est relié par cette première borne du condensateur d'une part par l'intermédiaire du commutateur (S32) à la seconde borne (12) et d'autre part par l'intermédiaire d'un commutateur (S15) au potentiel de référence (17) et par sa seconde borne d'une part par l'intermédiaire du commutateur (S22) de la première borne (11), et d'autre part par l'intermédiaire d'un commutateur (S51) à l'entrée inverseuse (25) de l'amplificateur opérationnel (19) et en outre par l'intermédiaire d'un commutateur (S41) à la sortie (20) de l'amplificateur, et que les commutateurs (S11, S21, S31, S51) sont fermés pendant la première phase de cadence, que les commutateurs (S13, S33, S41, S12) sont fermés pendant la seconde phase de cadence, que les commutateurs (S22, S32, S43, S24) sont fermés pendant la troisième phase de cadence, que le commutateur (S15) est fermé pendant la première et la seconde phases de cadence, que le commutateur (S14) est fermé pendant la première et la troisième phases de cadence et que le commutateur (S23) est fermé pendant la seconde et la troisième phases de cadence (Figures 5, 6).

# FIG 1

# FIG 2

# FIG 3

$$L = \frac{T^2}{4C_L}$$

FIG 4

FIG 5

FIG 6